Europäisches Patentamt

European Patent Office

Office européen des brevets

(19)

(11) EP 0 569 700 B1

(12) **EUROPÄISCHE PATENTSCHRIFT**

(45) Veröffentlichungstag und Bekanntmachung des Hinweises auf die Patenterteilung:
**17.03.1999 Patentblatt 1999/11**

(51) Int Cl.6: **G01R 15/24**, G01R 29/08, G01D 5/26

(21) Anmeldenummer: **93105466.2**

(22) Anmeldetag: **02.04.1993**

(54) **Faseroptischer Sensor**

Optical fiber sensor

Capteur à fibre optique

(84) Benannte Vertragsstaaten:
**DE FR GB**

(30) Priorität: **15.05.1992 DE 4216152**

(43) Veröffentlichungstag der Anmeldung:
**18.11.1993 Patentblatt 1993/46**

(73) Patentinhaber: **ASEA BROWN BOVERI AG**
**5400 Baden (CH)**

(72) Erfinder: **Bohnert, Klaus, Dr.**
**CH-5443 Niederrohrdorf (CH)**

(74) Vertreter: **Kaiser, Helmut, Dr. et al**
**Asea Brown Boveri AG**
**Immaterialgüterrecht (TEI)**
**Haselstrasse 16/699**
**5401 Baden (CH)**

(56) Entgegenhaltungen:
EP-A- 0 393 382          EP-A- 0 529 339
DE-A- 3 311 809          DE-A- 4 025 911

- OPTICS LETTERS, Bd.17, Nr.9, 1. Mai 1992, US Seiten 694 - 696 K.BOHNERT ET AL. 'Interrogation of a remote elliptical-core dual-mode fiber strain sensor by using a tandem interferometer configuration'
- IEEE CIRCUITS AND DEVICES, Bd.6, Nr.6, November 1990, NEW YORK US Seiten 13 - 19 A.DANDRIDGE 'A slew of general purpose devices...'
- APPLIED OPTICS, BAND 29, SEITEN 4473-4480

**Beschreibung**

Die Erfindung bezieht sich auf das Gebiet der optischen Messung elektrischer Grössen. Sie betrifft einen faseroptischen Sensor, umfassend

a) eine Mehr-Moden-Laserdiode als Lichtquelle;

b) ein piezoelektrisches Sensorelement;

c) eine erste Zwei-Moden-Faser mit einem Eingangsende und einem anderen Ende, in der sich der $LP_{01}$-Grundmodus und der gerade $LP_{11}$-Modus ausbreiten können, und welche zumindest teilweise an dem Sensorelement so fixiert ist, dass eine Dimensionsänderung des Sensorelements in einem elektrischen Feld zu einer Längenänderung in der ersten Zwei-Moden-Faser führt; und

(d) Mittel zum Messen der feldbedingten Längenänderung der ersten Zwei-Moden-Faser, welche Mittel eine zweite Zwei-Moden-Faser umfassen, wobei

e) die Parameter der beiden Zwei-Moden-Fasern und damit die relativen Gangunterschiede (Delta $L_1$, Delta $L_2$), die die Moden in den einzelnen Zwei-Moden-Fasern akkumulieren, so auf die Kohärenzeigenschaften der Lichtquelle abgestimmt sind, dass der Interferenzkontrast (V) für die genannten Gangunterschiede (Delta $L_1$, Delta $L_2$) und für die Summe dieser Gangunterschiede (Delta $L_1$ + Delta $L_2$) jeweils ungefähr gleich Null ist und für die Differenz der genannten Gangunterschiede (Delta L1 - Delta L2) ein absolutes oder relatives Maximum annimmt; und

f) die zweite Zwei-Moden-Faser zumindest teilweise an einem piezoelektrischen Modulator (8) fixiert ist;

Ein solcher faseroptischer Sensor ist z.B. aus der Veröffentlichung von K. Bohnert, G. de Witt und J. Nehring in Optics Letters 17 (9), S. 694-696, May 1992, bekannt.

**STAND DER TECHNIK**

In verschiedenen Druckschriften wie z.B. den Europäischen Patentanmeldungen EP-A1-0 316 619 und EP-A1-0 316 635 oder den Artikeln von K. Bohnert und J. Nehring in Appl.Opt. 27, S.4814-4818 (1988), bzw. Opt.Lett. 14, S.290-292 (1989), sind bereits faseroptische Sensoren zur Messung von elektrischen Feldern und Spannungen beschrieben worden.

Das dabei verwendete Messprinzip beruht auf dem inversen Piezoeffekt in Materialien mit ausgesuchter Kristallsymmetrie. Die zeitlich periodische Dimensionsänderung, die ein entsprechender piezoelektrischer Körper in einem elektrischen Wechselfeld erfährt, wird auf eine an dem Körper fixierte Glasfaser übertragen. Die Längenänderung der Faser ist dann proportional zur Feld- bzw. Spannungsamplitude und wird interferometrisch gemessen und ausgewertet.

Für die interferometrische Messung können verschiedene Arten von Glasfaser-Interferometern eingesetzt werden. Aufgrund seiner Einfachheit ist von diesen Arten das aus dem Artikel von B. Y. Kim et al., Opt.Lett. 12, S. 729-731 (1987), bekannte Zwei-Moden-Faser-Interferometer von besonderem Interesse. Die Parameter der Sensorfaser sind bei diesem Interferometer so gewählt, dass sich in der Faser genau zwei Moden (der $LP_{01}$-Grundmodus und der gerade $LP_{11}$-Modus) ausbreiten können.

Beim Zwei-Moden-Faser-Interferometer wird Licht aus einer kohärenten Lichtquelle, Z.B. einer Laserdiode, durch eine Zwei-Moden-Faser geschickt, welche an einem piezoelektrischen Sensorelement für das elektrische Feld E fixiert ist. Durch das Licht werden die beiden Moden angeregt und breiten sich in der Faser unterschiedlich aus. Am Faserende kann man dann ein Interferenzmuster beobachten, welches sich aus der Überlagerung dieser beiden Moden ergibt. Eine Längenänderung der Faser führt dabei zu einer differentiellen Phasenverschiebung zwischen beiden Moden, die sich in einer entsprechenden Änderung des Interferenzmusters äussert.

Das Interferenzmuster weist zwei nebeneinanderliegende Substrukturen auf, welche mit zwei Detektoren (z. B. in Form von Photodioden) detektiert werden. An deren Ausgang liegen zwei um 180° phasenverschobene Signale $V_{11}$ und $V_{12}$ vor:

$$(1) \qquad V_{11} = (1/2)V_0(I + a*\cos\phi(t))$$

$$(2) \qquad V_{12} = (1/2)V_0(I - a*\cos\phi(t))$$

mit $\phi(t) = A*\sin\omega t + \theta(t)$. Die Phasenverschiebung $\phi(t)$ zwischen den beiden Moden setzt sich also zusammen aus einem durch das zu messende Wechselfeld hervorgerufenen zeitlich periodischen Anteil $A*\sin\omega t$ (A ist dabei propor-

tional zur Amplitude des Feldes) und einem willkürlichen Phasenterm $\theta(t)$, der sich z.B. infolge von temperaturbedingten Fluktuationen der Faserlänge ebenfalls zeitlich ändern kann. $V_0$ schliesslich ist proportional zur optischen Leistung und a ist ein Mass für den Interferenzkontrast.

Der gesuchte Term $A*\sin\omega t$ wird häufig mit einem Homodyn-Detektionsverfahren mit aktiver Phasenkompensation aus den Ausgangssignalen der Detektoren gewonnen (für einen faseroptischen Sensor mit Ein-Moden-Faser siehe dazu: D. A. Jackson et al., Appl.Opt. 19, S.2926-2929 (1980); ein entsprechender faseroptischer Sensor mit Zwei-Moden-Faser ist in der eingangs zitierten Europäischen Anmeldung EP-A1-0 433 824 beschrieben). Bei diesem Verfahren wird die Sensorfaser zusätzlich über einen piezoelektrischen Modulator geführt. Mit Hilfe dieses Modulators 4 wird die Phasenverschiebung $\phi(t)$ auf +(pi/2) oder -(pi/2) (modulo 2pi) geregelt. Der Modulator ist dazu Bestandteil eines aus den Detektoren, einem Subtrahierer und einem Quadraturregler bestehenden Regelkreises, welcher die Differenzspannung

$$(3) \qquad V = V11 - V12 = V0*a*\cos\phi(t)$$

jeweils auf Null regelt.

Die beiden Anteile $A*\sin\omega t$ und $\theta(t)$ der Phasenverschiebung werden also durch den Modulator über eine entsprechende (entgegengesetzte) Längenänderung der Faser gerade ausgeglichen. Die am Modulator anliegende Spannung enthält einen langsam variierenden Anteil, der proportional zu $\theta(t)$ ist, und einen periodischen Anteil, der proportional zu $A*\sin\omega t$ ist. Der gesuchte Anteil $A*\sin\omega t$ wird über ein Hochpassfilter ausgefiltert und kann am Signalausgang abgenommen werden. Das Ausgangssignal ist dadurch unabhängig von etwaigen Fluktuationen der Laserintensität (d.H. $V_0$) und des Interferenzkontrastes a.

Der gesuchte Term $A*\sin\omega t$ kann andererseits auch mit Hilfe eines Homodyn-Verfahrens, bei dem eine Träger-Phasenmodulation erzeugt wird, bzw. mit Hilfe eines synthetischen Heterodyn-Verfahrens gewonnen werden (siehe hierzu: A.Dandridge et al., IEEE J. of Quantum Electronics QE-18, 1647 (1982); J.H. Cole et al., IEEE J. of Quantum Electronics QE-18, 694 (1982); E.L. Green et al., IEEE J. of Quantum Electronics QE-18, 1639 (1982)). Bei diesen Verfahren ist ebenfalls ein Modulator vorgesehen. Dieser wird von einem Oszillator angesteuert, wobei das Oszillatorsignal auch einer Demodulationselektronik zugeführt ist. Bei beiden Verfahren genügt es, lediglich eines der beiden vorgenannten Interferenzmuster auszuwerten. Sie unterscheiden sich lediglich durch die Art der erfoderlichen Demodulationselektronik.

In einer Reihe von praktischen Anwendungen des Sensors (z.B. bei der Spannungsmessung in Freiluftanlagen) können verhältnismässig grosse Abstände zwischen dem eigentlichen Sensorkopf und der Sensorelektronik auftreten (10 m bis einige 100 m). Es ist unzweckmässig, diese Abstände mit der Zwei-Moden-Faser selbst zu überbrükken, da sich der Einfluss externer Störungen (Temperaturschwankungen, mechanische Erschütterungen etc.) mit zunehmender Faserlänge entsprechend vergrössert und das Signal/Rausch-Verhältnis verschlechtert. Die Lichtzuführung von der Laserdiode zum Interferometer und die Rückführung der Ausgangssignale des Interferometers sollten vielmehr über separate Glasfasern erfolgen, die nicht Bestandteil des Interferometers sind.

Bei dem oben beschriebenen Homodyn-Verfahren mit einem aktiven Phasen-Modulator wäre aber zusätzlich zu den Verbindungs-Glasfasern auch noch eine elektrische Verbindung zwischen der Sensorelektronik und dem Sensorkopf zur Ansteuerung des Modulators erforderlich. Die Attraktivität eines mit diesem Interferometertyp arbeitenden Sensors wäre dadurch sehr beschränkt.

Es ist deshalb in zwei älteren Deutschen Patentanmeldungen DE 41 14 253 und 41 15 370) vorgeschlagen worden, anstelle der bekannten aktiven Signaldetektion, die einen zusätzlichen Modulator in der Messfaser mit entsprechender elektrischer Zuleitung erfordert, eine passive Signaldetektion vorzusehen, die auf dem Guoy-Effekt (siehe dazu: S. Y. Huang et al., Springer Proc. in Physics, Vol.44 "Optical Fiber Sensors", S.38-43, Springer Verlag Berlin, Heidelberg (1989)), d.h. der zusätzlichen Phasenverschiebung zwischen den Moden und der daraus resultierenden Änderung des Interferenzmusters beim Übergang vom Nah- zum Fernfeld beruht: Die Substrukturen des Nah- und Fernfeldes (insgesamt 4) werden dabei im Sensorkopf mit optischen Mitteln separiert und können über separate Glasfasern zu einer entfernten Auswerteelektronik übertragen werden. Dort kann unter Verwendung von wenigstens drei dieser vier Substrukturen die gewünschte Information über die Längenänderung der Messfaser gewonnen werden. Mit dieser vorgeschlagenen Lösung wird zwar eine vollständige elektrische Trennung zwischen Sensorkopf und Auswerteelektronik erreicht. Jedoch wird dieser Vorteil durch eine relativ aufwendige Optik und Elektronik erkauft. Darüberhinaus muss eine Monomode-Laserdiode verwendet werden, die besondere Massnahmen zur Unterdrückung der Lichtrückstreuung aus dem Sensor in die Diode erforderlich macht.

In der eingangs zitierten Veröffentlichung von K. Bohnert, G. de Witt und J. Nehring, "Interrogation of a remote elliptical-core dual-mode fiber strain sensor by using a tandem interferometer configuration", Optics Letters 17 (9), S. 694-696, May 1 1992, wird das Problem einer störungsfreien optischen Signalübertragung zwischen Sensorkopf und Auswerteeinheit rein optisch gelöst, indem anstelle einer durchgehenden Zwei-Moden-Faser zwei getrennte Zwei-Moden-Fasern am Sensorkopf (Sensorfaser) bzw. in der Auswerteeinheit (Referenzfaser) nach Art eines Tandem-Interferometers hintereinandergeschaltet werden. Die optische Übertragung geschieht über zwei ebenfalls getrennte, störunempfindliche Monomodefasern. In der Referenzfaser wird die Interferenz zwischen dem $LP_{01}$- und dem $LP_{11}$-Mode aus der Sensorfaser rekonstruiert und bei Bedarf gemäss des gewählten Signalauswertungsverfahrens moduliert.

Die Tandemkonfiguration zeichnet sich somit durch eine gute Störunterdrückung auf beiden Übertragungsstrecken und durch die Verwendbarkeit eines lokalen, d. h. direkt auf die Referenzfaser einwirkenden Modulators aus.

Nachteilig an dieser Lösung ist es jedoch, dass bei langen Übertragungsstrecken sehr grosse Mengen an Spezial fasern (polarisationserhaltende Monomodefasern) zur Überbrückung zwischen Sensor- und Referenzfaser benötigt werden und eine Längenanpassung beidseitig verspleisster Zwei-Moden-Fasern erforderlich ist. Im Falle eines in einem GIS-Gehäuse eingeschlossenen Sensors, wie er in der DE 40 25 911 A1 vorgesehen ist, sind zudem zwei gasdichte polarisationserhaltende Monomodefaser-Durchführungen notwendig. Deshalb ist eine weitere Vereinfachung der Tandemkonfiguration besonders aus wirtschaftlichen Gründen sehr wünschenswert.

Es ist Aufgabe der vorliegenden Erfindung, einen faseroptischen Sensor in einer Tandemkonfiguration dahingehend weiterzuentwickeln, dass einerseits eine Vereinfachung der optischen Übertragungsstrecke zwischen Sensorkopf und Auswerteelektronik und andererseits eine sehr geringe Störempfindlichkeit und sehr hohe Messgenauigkeit erzielt werden.

Die Aufgabe wird bei einem Sensor der eingangs genannten Art durch die Merkmale der Ansprüche 1 - 4 gelöst.

Nach der Erfindung wird demnach u.a. für die Messung von dem Prinzip der Weisslicht-Interferometrie Gebrauch gemacht: Licht von einer Mehr-Moden-Laserdiode wird über einen Faserkoppler oder Strahlteiler sowie über eine insensitive Monomode-Faser einer ersten Zwei-Moden-Faser (Sensorfaser) zugeführt. Die Ankopplung am Eingangsende der ersten Zwei-Moden-Faser erfolgt so, dass die beiden ausbreitungsfähigen Moden ($LP_{01}$-Grundmodus und gerader $LP_{11}$-Modus) vorzugsweise mit gleicher Intensität angeregt werden. Dies erreicht man durch einen geeignet gewählten transversalen Versatz zwischen den optischen Achsen der Fasern. Indem das andere Ende der ersten Zwei-Moden-Faser verspiegelt ist, werden dort die sich von dem Eingangsende aus ausbreitenden Moden reflektiert und laufen zu dem Eingangsende wieder zurück, wo sie zu etwa gleichen Teilen in die Monomode-Faser eingekoppelt und über diese zu dem Faserkoppler bzw. dem Strahlteiler zurück übertragen werden. In der ersten Zwei-Moden-Faser erfahren die beiden Moden einen optischen Gangunterschied Delta $L_1$, für den der Interferenzkontrast vernachlässigbar klein ist. Es treten deshalb am Eingangsende der ersten Zwei-Moden-Faser zwischen den beiden reflektierten Moden keine Interferenzeffekte auf.

Vermittels des Faserkopplers bzw. des Strahlteilers wird ein Teil des reflektierten Lichtes bzw. der vorgenannten zwei Moden in eine zweite Zwei-Moden-Faser eingekoppelt. Diese dient als Referenzfaser und weist vorzugsweise gleiche Faserparameter wie die erste Zwei-Moden-Faser auf. Die Referenzfaser wird erfindungsgemäß in einer Reflexionskonfiguration betrieben. In einer Transmissionskonfiguration muss sie doppelt so lang wie in einer Reflexionskonfiguration sein.

Die Einkopplung in die Referenzfaser erfolgt wiederum so, dass beide Moden etwa gleich stark angeregt werden. Licht, welches sich in der ersten Zwei-Moden-Faser im Grundmodus $LP_{01}$ ausgebreitet hat, breitet sich zu etwa gleichen Teilen im $LP_{01}$- und im geraden $LP_{11}$-Modus in der zweiten Zwei-Moden-Faser aus. Gleiches gilt für Licht, welches sich in der ersten Zwei-Moden-Faser im $LP_{11}$-Modus ausgebreitet hat.

Sofern die Sensorfaser und die Referenzfaser hinsichtlich ihrer Faserparameter und dabei insbesondere hinsichtlich ihrer effektiven Länge im wesentlichen identisch ausgebildet sind, ergeben sich nach dem Durchlaufen der zweiten Zwei-Moden-Faser (bei Reflexionbetrieb in beiden Richtungen) zwischen den Lichtwellen des $LP_{01}$-Modus einerseits und den Wellen des $LP_{11}$-Modus andererseits Gangunterschiede von Null, Delta $L_1$ und 2*Delta $L_1$. Innerhalb der einzelnen Moden gibt es Gangunterscheide von Delta $L_1$. Modenanteile mit dem Gangunterschied Null interferieren miteinander, während die übrigen Anteile einen konstanten Intensitätsuntergrund liefern. Bei dieser Konfiguration ist auch die Differenz der Gangunterschiede (Delta $L_1$ - Delta $L_2$), welche die Moden in diesen Fasern akkumulieren, gleich Null, wobei der Interferenzkontrast V (Delta $L_1$ - Delta $L_2$) sein absolutes Maximum erreicht. Der Verlauf der Funktion V in Abhängigkeit des Gangunterschiedes wird weiter unten noch erläutert.

Grundsätzlich könnten die beiden Zwei-Moden-Fasern auch unterschiedliche Faserparameter aufweisen. So könnten z.B. die effektive Länge der Sensorfaser und der Referenzfaser abweichend voneinander derart gewählt werden, dass der Interferenzkontrast lediglich ein relatives Maximum der Funktion V (Delta $L_1$ - Delta $L_2$) annimmt. Dies würde sich jedoch im vorliegenden Zusammenhang aufgrund des dann kleineren und auch von der Laserleistung abhängigen Wertes von V (Delta $L_1$ - Delta $L_2$) eher nachteilig auswirken.

Aus der gemäss der vorliegenden Erfindung bezüglich der ersten Zwei-Moden-Faser gewählten Reflexionskonfiguration ergeben sich insbesondere folgende Vorteile:

-  Es wird nur eine einzige Monomode-Faser zur Übertragung des Lichts zwischen der Lichtquelle sowie den Messmitteln einerseits und der ersten Zwei-Moden- bzw. Sensorfaser benötigt;

- Indem das Licht die Sensorfaser zweimal durchlaufen muss, wird die durch das piezoelektrische Sensorelement hervorgerufene Phasenmodulation und dadurch auch die Messempfindlichkeit der Anordnung verdoppelt.

An dieser Stelle sei darauf hingewiesen, dass ein solches als Tandem-Interferometer bezeichnetes System grundsätzlich für herkömmliche Interferometer (Michelson) bereits aus dem Stand der Technik bekannt ist (siehe z.B. A. S. Gerges et al., Appl. Optics Vol.29, No.30, S.4473-4480 (1990)).
Bevorzugte Ausführungsformen der Erfindung ergeben sich aus den abhängigen Ansprüchen.

KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig. 1    das grundsätzliche Schema eines Tandem-Interferometers mit zwei Zwei-Moden-Fasern;

Fig. 2    den Interferenzkontrast V für ein mit einer Mehr-Moden-Laserdiode beleuchtetes Michelson-Interferometer in Abhängigkeit vom Gangunterschied Delta L;

Fig. 3A   die Intensität I am Ausgang eines Tandem-Interferometers für das Interferenzpaket 0-ter Ordnung in Abhängigkeit von der Differenz im Gangunterschied (Delta $L_1$ - Delta $L_2$);

Fig. 3B   die Fig. 3A entsprechende Darstellung für "Interferenzpakete" mit Ordnungen bis ± 2;

Fig. 4    die Intensität I für V=1 in Abhängigkeit von der Phase; und

Fig. 5-11  den schematischen Aufbau verschiedener Sensoren.

WEGE ZUR AUSFÜHRUNG DER ERFINDUNG

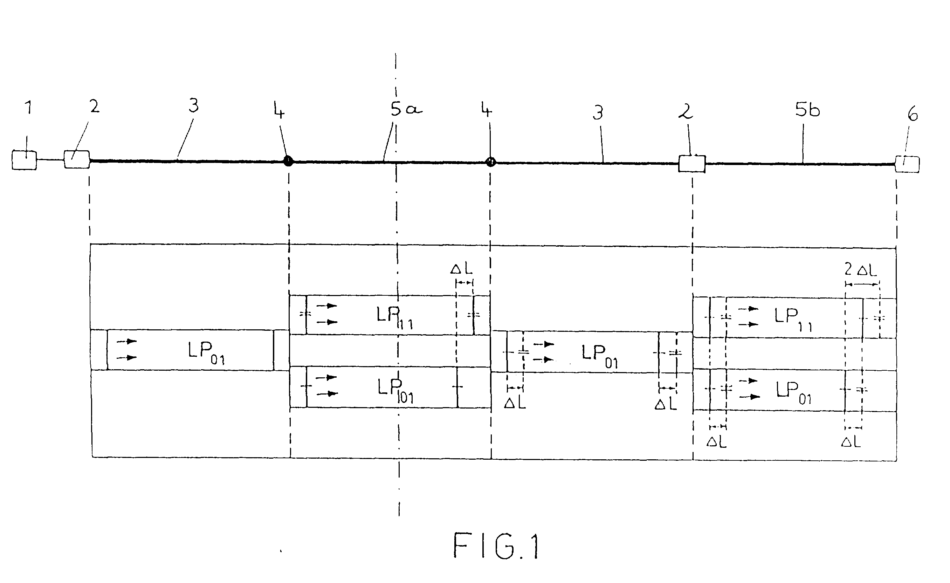

Der prinzipielle Aufbau sowie die Funktion eines Sensors und die Ausbreitung einer Wellenfront eines einzelnen, willkürlich herausgegriffenen Wellenzuges werden zunächst anhand von Fig. 1 erläutert. Das Licht aus einer Lichtquelle 1, einer Mehr-Moden-Laserdiode, wird über einen Faserkoppler oder einen Strahlteiler 2 in eine (polarisationserhaltende) Monomode-Faser 3 eingekoppelt. Dort breitet es sich im Grundmodus $LP_{01}$ aus. Die betrachtete Wellenfront regt in einer durch einen Spleiss 4 an die Monomode-Faser 3 angeschlossenen ersten Zwei-Moden-Faser 5a zwei neue Wellenfronten an, die sich im $LP_{01}$- und im geraden $LP_{11}$-Modus ausbreiten. Die erste Zwei-Moden-Faser 5a weist an ihrem dem Spleiss 4 gegenüberliegenden Ende eine verspiegelte Endfläche auf. An dieser werden die beiden Moden reflektiert. Die Lage der verspiegelten Endfläche ist in Fig. 1 durch eine strichpunktierte Linie schematisch gekennzeichnet. Fig. 1 ist demnach so zu verstehen, dass die Wellenfronten jenseits, d.h. rechts von der strichpunktierten Linie in Wirklichkeit in umgekehrter Richtung wieder zurücklaufen.
Beide Fronten sind am Anfang der ersten Zwei-Mode-Faser 5a noch in Phase, da sie von einer gemeinsamen Ausgangsfront erzeugt werden. Die Ankopplung an die erste Zwei-Moden-Faser 5a in dem genannten Spleiss 4 erfolgt vorzugsweise so, dass die Intensitäten der $LP_{01}$- und $LP_{11}$-Moden annähernd gleich sind.
Da die effektiven Brechungsindizes $n(LP_{01})$ und $n(LP_{11})$ für die beiden Moden verschieden sind, hat sich nach dem Durchlaufen der ersten Zwei-Moden-Faser 5a in beiden Richtungen, d.h. vom Spleiss 4 bis zu dem verspiegelten Ende und wieder zurück, zwischen den beiden Fronten ein optischer Gangunterschied

$$(4) \qquad Delta\ L = Delta\ L_1 = l(n(LP_{01})\text{-}n(LP_{11}))$$

akkumuliert. l bezeichnet hier die effektive Länge, d.h. die doppelte geometrische Länge der ersten Zwei-Moden-Faser 5a. Diese ist derart gewählt, dass nach dem Durchlaufen der effektiven Länge der ersten Zwei-Moden-Faser 5a keine Interferenzeffekte zwischen den beiden reflektierten Wellenfronten auftreten.
Die beiden reflektierten Wellenfronten regen in der Monomode-Faser 3 zwei neue Fronten an, die sich beide im $LP_{01}$-Modus ausbreiten und zu dem Faserkoppler bzw. Strahlteiler 2 zurücklaufen. Der Gangunterschied Delta L zwischen den beiden Fronten bleibt in der Monomode-Faser 3 erhalten. Im Spleiss 4 werden die $LP_{01}$- und $LP_{11}$-Moden etwa zu gleichen Anteilen in die Monomode-Faser 3 eingekoppelt.

Vermittels des Faserkopplers oder Strahlteilers 2 wird ein Teil der Intensität der genannten Moden in eine zweite Zwei-Moden-Faser 5b eingekoppelt. Diese wird im Unterschied zu der ersten Zwei-Moden-Faser 5a in Transmissionskonfiguration betrieben. Ausführungsbeispiele der Erfindung, bei denen auch die zweite Zwei-Moden-Faser 5b in Reflexionskonfiguration betrieben wird, werden weiter unten noch erläutert. In der zweiten Zwei-Moden-Faser 5b regen die beiden Moden jeweils zwei neue Fronten an, von denen sich jeweils eine im $LP_{01}$- und eine im $LP_{11}$-Mode ausbreitet. Die $LP_{01}$- und $LP_{11}$-Moden haben wiederum näherungsweise gleiche Intensitäten (um die Wellenfronten besser verfolgen zu können, sind in Fig. 1 solche, die aus dem $LP_{01}$-Modus der ersten Zwei-Moden-Faser 5a stammen, mit einem Querstrich, und solche, die aus dem $LP_{11}$-Modus stammen, mit zwei Querstrichen versehen).

Der Gangunterschied Delta L zwischen den $LP_{01}$- bzw. den $LP_{11}$-Frontenpaaren bleibt entlang der zweiten Zwei-Moden-Faser 5b erhalten. Zwischen dem $LP_{01}$-Frontenpaar einerseits und dem $LP_{11}$-Frontenpaar andererseits akkumuliert sich jedoch ein Phasenunterschied Delta $L_2$. Wenn die beiden Zwei-Moden-Fasern 5a und 5b hinsichtlich ihrer Faserparameter sowie ihrer effektiven Länge (d.h. nicht notwendig auch hinsichtlich ihrer geometrischen Länge) gleich bemessen sind, gilt: Delta $L_2$ = Delta $L_1$ = Delta L . Nach dem Durchlaufen der effektiven Länge der zweiten Zwei-Moden-Faser 5b gibt es zwischen den Lichtwellen des $LP_{01}$-Modus einerseits und den Wellen des $LP_{11}$-Modus andererseits Gangunterschiede von Null, Delta $L_1$ und 2*Delta $L_1$. Innerhalb der einzlnen Moden gibt es Wellen mit dem Gangunterschied Delta L1. Modenanteile mit dem Gangunterschied Null interferieren miteinander, während die übrigen Anteile einen konstanten Intensitätsuntergrund liefern. Die Interferenz wird in einer Detektionseinheit 6 ausgewertet.

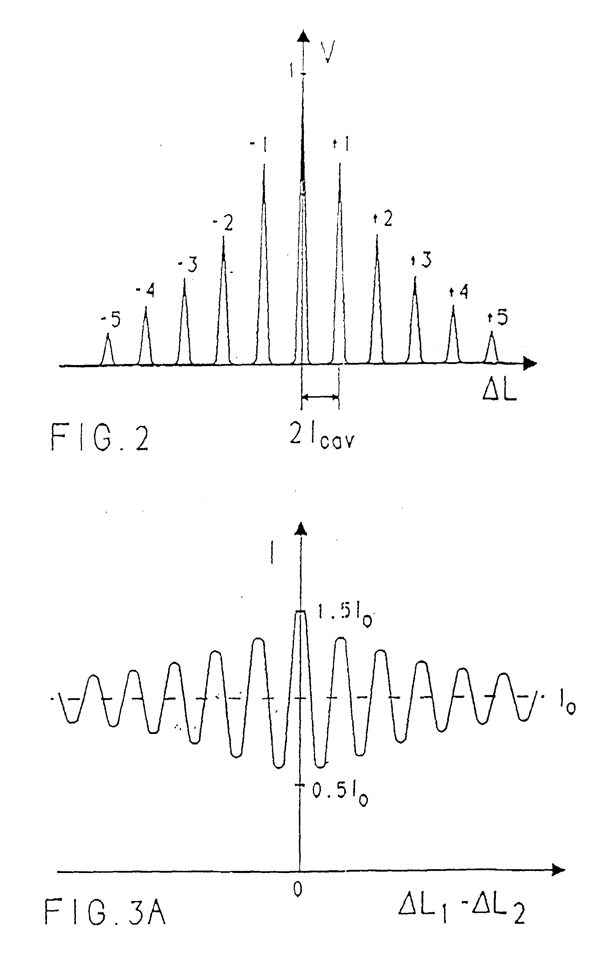

Zum weiteren Verständnis des Tandem-Zwei-Moden-Faser-Interferometers nach der Erfindung wird zunächst ein einzelnes Michelson-Interferometer mit einer Mehr-Moden-Laserdiode als Lichtquelle betrachtet, wie es in dem bereits zitierten Artikel von A. S. Gerges et al. beschrieben ist. Trägt man den Interferenzkontrast V als Funktion des optischen Weglängenunterschieds Delta L zwischen den beiden Interferometerzweigen auf, so ergibt sich eine Serie von äquidistanten Spitzen wachsender Ordnung ±1, ±2, ±3, usw., die symmetrisch bezüglich der Spitze bei Delta L = 0 liegen (Fig. 2). Der Interferenzkontrast V ist dabei definiert als

$$(5) \qquad V = \frac{I_{max} - I_{min}}{I_{max} + I_{min}},$$

wobei $I_{max}$ und $I_{min}$ die Intensitäten der Maxima und Minima des Interferenzstreifenmusters sind. Die Lage der Spitzen ist gegeben durch

$$(6) \qquad \text{Delta L} = 2*p*l_{cav} \qquad p = 0, \pm1, \pm2,..$$

mit der Ordnungszahl p und der optischen Länge $l_{cav}$ des Laserresonators.

Zwischen den Spitzen ist V sehr klein, so dass hier nahezu keine Interferenz auftritt. Für gleiche Amplituden der interferierenden Wellen ist V(Delta L=0) = 1. Mit wachsender Ordnungszahl p fällt die Höhe K der Spitzen monoton ab, gemäss der Beziehung K(Delta L) = exp(-Delta $L/L_{cm}$), wobei $L_{cm}$ die der spektralen Lasermodenbreite entsprechende Kohärenzlänge ist. K geht also für I Delta L I >> $L_{cm}$ gegen Null. Hier ist vorausgesetzt, dass die Lasermoden durch eine Lorentz-Funktion beschrieben werden können.

Beim Zwei-Moden-Faser-Interferometer treten an die Stelle der Zweige des Michelson-Interferometers die $LP_{01}$- und $LP_{11}$-Moden. Mit zunehmender effektiver Faserlänge 1 wächst der Gangunterschied Delta L = l(n($LP_{01}$)-n($LP_{11}$)) zwischen den Moden linear mit 1 an. Der Interferenz kontrast V(I) als Funktion der effektiven Faserlänge durchläuft dann die gleiche Serie von Spitzen wie beim Michelson-Interferometer. Die Maxima liegen bei effektiven Faserlängen

$$(7) \qquad l_p = 2*p*l_{cav}/(n(LP_{01})-n(LP_{11})).$$

Der Faserlängenunterschied zwischen benachbarten Spitzen ist folglich

$$(8) \qquad \text{Delta 1} = 2*l_{cav}/\text{Delta } n_{eff}$$

mit Delta $n_{eff}$ = n($LP_{01}$)-n($LP_{11}$).

Damit am Ende der effektiven Länge der ersten Zwei-Moden-Faser 5a (d.h. an deren geometrischem Anfang) keine Interferenzeffekte auftreten (diese hätten unerwünschte Intensitätsschwankungen zur Folge), muss entweder der von der effektiven Faserlänge abhängige Gangunterschied Delta L sehr viel grösser sein als $L_{cm}$, oder 1 muss in einem Minimum zwischen zwei Spitzen der Funktion V(l) liegen.

Die Lichtintensität am Ausgang des Tandem-Zwei-Modenfaser-Interferometers ist gegeben durch (analog zu Gleichung (7) in dem Artikel von A. S: Gerges et al.):

$$(9) \qquad I = I_0 \, [1 + V(\text{Delta } L_1)\cos(\phi_1) + V(\text{Delta } L_2)\cos(\phi_2)$$

$$+ (1/2)V(\text{Delta } L_1 + \text{Delta } L_2)\cos(\phi_1 + \phi_2)$$

$$+ (1/2)V(\text{Delta } L_1 - \text{Delta } L_2)\cos(\phi_1 - \phi_2)]$$

$\phi_1$ und $\phi_2$ sind die den Gangunterschieden Delta $L_1$ und Delta $L_2$ entsprechenden Phasendifferenzen:

$$(10) \qquad \phi_1 = \frac{2 \ast pi \ast f_0}{c} \text{ Delta } L_1$$

und

$$(10) \qquad \phi_2 = \frac{2 \ast pi \ast f_0}{c} \text{ Delta } L_2 \, .$$

$f_0$ ist die mittlere Frequenz der Laserdiode, c ist die Lichtgeschwindigkeit. $I_o$ ist proportional zur optischen Leistung der Laserdiode. Delta L1 und Delta L2 sind gegeben durch

$$(12) \qquad \text{Delta } L_1 = I_1 \ast \text{Delta } n^{(1)}_{eff}$$

$$(13) \qquad \text{Delta } L_2 = I_2 \ast \text{Delta } n^{(2)}_{eff} \, .$$

$I_1$ und $I_2$ sind die effektiven Längen der beiden Zwei-Moden-Fasern 5a und 5b, wobei die effektive Länge $I_2$ der zweiten Zwei-Moden-Faser 4b im Beispiel von Fig. 1 gerade deren wirklicher, d.h. deren geometrischer Länge entspricht; Delta $n^{(1)}_{eff}$ und Delta $n^{(2)}_{eff}$ sind die Unterschiede der effektiven Brechungsindices der Moden in beiden Fasern.

Wie schon erwähnt ist Delta $n^{(1)}_{eff}$ = Delta $n^{(2)}_{eff}$ = Delta $n_{eff}$, $I_1 = I_2$ und folglich Delta $L_1$ = Delta $L_2$. Für einen gegebenen Fasertyp wird 1 dann so gewählt, dass

$$(14) \qquad V(\text{Delta } L_1) = V(\text{Delta } L_2) \sim 0$$

ist, und dass ausserdem

$$(15) \qquad V(\text{Delta } L_1 + \text{Delta } L_2) = \sim 0$$

ist.

Gleichung (9) lautet dann

$$(16) \qquad I = I_0 (1 + (1/2)V(\text{Delta } L_1 - \text{Delta } L_2)\cos z)$$

mit

$$z = 2 \ast pi \ast f_0 \ast (I/c)(\text{Delta } L_1 - \text{Delta } L_2).$$

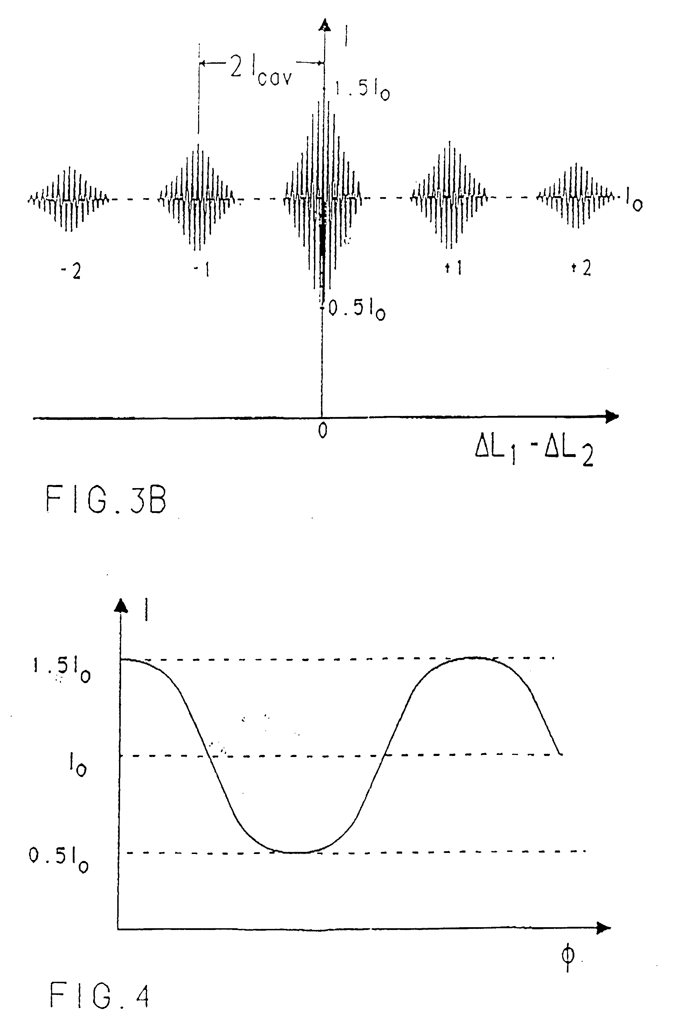

Das Tandem-Zwei-Moden-Faser-Interferometer verhält sich damit wie ein einzelnes Interferometer mit dem Gangunterschied Delta L = Delta $L_1$-Delta $L_2$, mit dem Unterschied, dass der Interferenz kontrast um einen Faktor 2 reduziert ist. Die Intensität I nach Gleichung (16) ist in den Figuren 3A und 3B schematisch dargestellt. Fig. 3A zeigt den unmittelbaren Bereich um Delta $L_1$-Delta $L_2$ = 0 (Ordnung p=0; IDelta $L_1$-Delta $L_2$I ≤ einige 100μm). Fig. 3B stellt einen grösseren Ausschnitt aus dem Wertebereich von Delta $L_1$-Delta $L_2$ dar mit "Interferenzpaketen" höherer Ordnung (IpI≤ 0).

Zum Vergleich seien nachfolgend einige Zahlenwerte für das Tandem-Zwei-Moden-Faser-Interferometer dem Michelson-Interferometer gegenübergestellt:

Michelson-Interferometer (in Luft):

Die Halbwertsbreite der Spitzen in der Funktion V(Delta L) liegt in Luft für viele kommerzielle Mehr-Moden-Laserdioden in der Grössenordnung 200 um. Die optische Länge $l_{cav}$ des Laserresonators beträgt ca. 1 mm. Der Abstand zweier Maxima ist damit etwa 2 mm. Die Höhe K der Maxima fällt gewöhnlich innerhalb der ersten 10 Ordnungen (IpI≤ 10) auf Werte von wenigen Prozent ab. Der Interferenzkontrast z.B. im Minimum zwischen den Maxima 7. und 8. Ordnung der Funktion V ist für eine Reihe von Laserdioden für Laserleistungen im Bereich der Nominalleistung in der Grössenordnung von 0,001 oder kleiner.

Tandem-Zwei-Moden-Faser-Interferometer:

Der Unterschied Delta $n_{eff}$ = n($LP_{01}$)-n($LP_{11}$) der effektiven Brechungsindizes ist stark vom Fasertyp abhängig. Für eine Zwei-Moden-Faser für eine Wellenlänge lambda von 780 nm kann er grob in dem Bereich zwischen 0,001 und 0,015 liegen.

Für eine Faser mit z.B. Delta $n_{eff}$ = 0,01 ergeben sich folgende Parameter: Die Halbwertsbreite der Spitzen der Funktion V(l) entspricht einem Faserlängenunterschied in der Grössenordnung von (200 μm)/Delta $n_{eff}$ = 2 cm. Damit der totale Gangunterschied Delta $L_1$-Delta $L_2$ des Tandem-Interferometers noch sicher innerhalb des "Interferenzpakets" 0-ter Ordnung (p=0) liegt, sollten demnach die effektiven Längen der beiden Zwei-Moden-Fasern 5a und 5b auf einige Millimeter genau miteinander übereinstimmen. In der Praxis können solche Toleranzen problemlos eingehalten werden.

Der Faserlängenunterschied zwischen zwei Maxima von V(l) ist (2 mm)/Delta $n_{eff}$ = 20 cm. Das Maximum 10-ter Ordnung tritt demnach bei einer effektiven Faserlänge von 2 m auf. Infolge des relativ grossen Abstands zweier Maxima von V(l) können die Faserlängen leicht so eingestellt werden, dass die Bedingungen gemäss Gleichung (14) und (15) erfüllt sind.

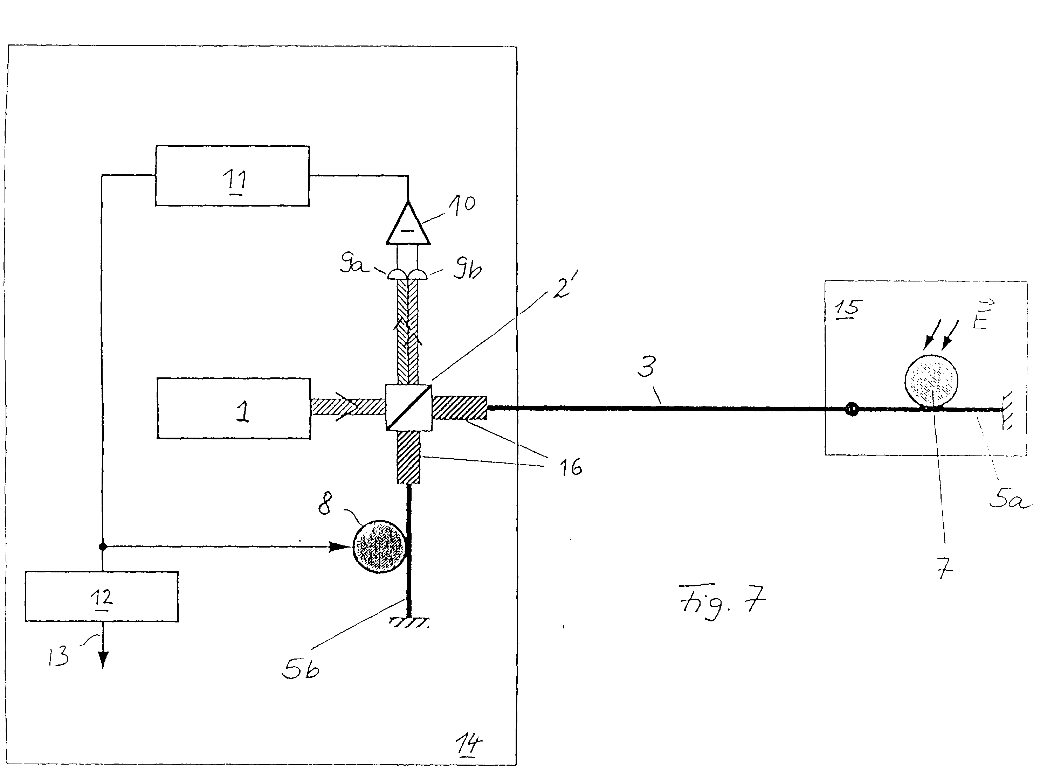

Nachfolgend werden, anhand der Figuren 7, 10 und 11 unterschiedliche Ausführungsformen für den Aufbau eines Sensors für die elektrische Feld- und Spannungsmessung nach der Erfindung dargestellt. Dabei sind übereinstimmende oder funktionell gleiche Elemente in den verschiedenen Ausführungsformen jeweils mit dem gleichen Bezugszeichen versehen.

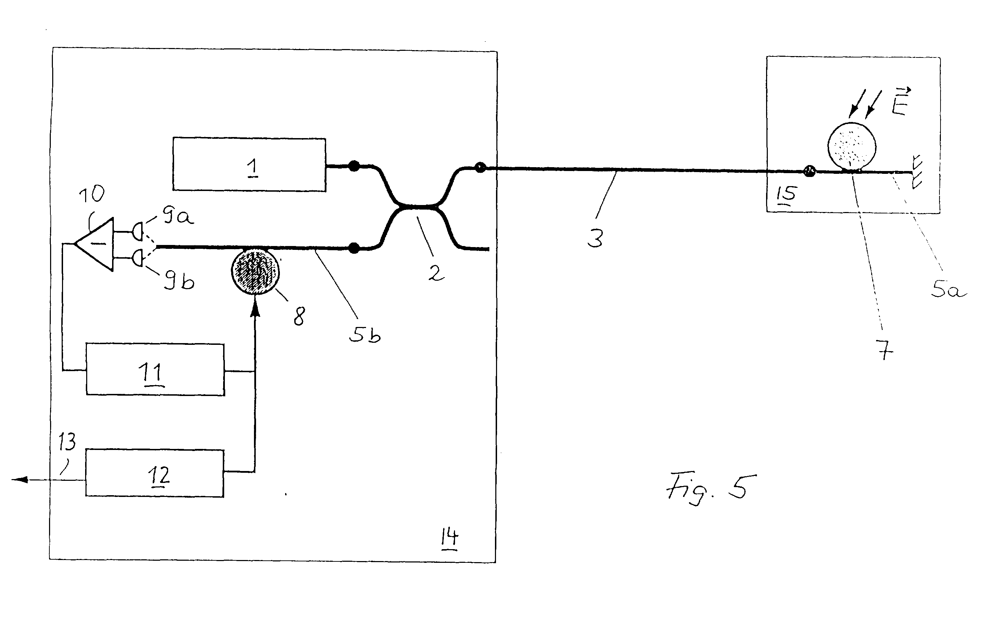

Zunächst wird auf Fig. 5 Bezug genommen. Hier ist eine Lichtquelle wieder mit 1, ein Faserkoppler mit 2, eine Monomode-Faser mit 3 und zwei Zwei-Moden-Fasern mit 5a bzw. 5b bezeichnet. In einem elektrischen Wechselfeld E moduliert ein piezoelektrisches Sensorelement 7 (z.B. ein Quarz) die Länge der ersten, als Sensorfaser dienenden Zwei-Moden-Faser 5a und damit auch den Phasenunterschied zwischen den beiden in dieser Faser angeregten Moden. Die Sensorfaser 5a ist an ihrem einen, rechten Ende verspiegelt und wird demnach in Reflexionskonfiguration betrieben. Die als Referenzfaser dienende zweite Zwei-Moden-Faser 5b wird dagegen in Transmission betrieben. Sie ist doppelt so lang wie die Sensorfaser 5a. Der Phasenunterschied der am Ende der Referenzfaser 5b interferierenden Wellen ist gegeben durch

$$(17) \qquad \phi(t) = A^*\sin(\omega^*t) + \phi^0_1(t) - \phi^0_2(t) \ .$$

$\phi^0_1(t)$ und $\phi^0_2(t)$ sind die Phasendifferenzen zwischend den Moden der beiden Zwei-Moden-Fasern 5a und 5b, wenn keine Modulation erfolgt. $\phi^0_1(t)$ und $\phi^0_2(t)$ können sich z.B. infolge von Temperaturschwankungen (temperaturabhängige Faserlängen) zeitlich ändern. Die Temperaturfluktuationen der Gangunterschiede sind jedoch sehr viel kleiner als die Breite der Spitzen der Funktion V(Delta L), so dass der Interferenzkontrast dadurch praktisch nicht verändert wird. Gleichung (16) lautet dann

$$(18) \qquad I=I_0 \ (I+(1/2)V\cos(A^*\sin(\omega^*t)+\phi^0_1(t)-\phi^0_2(t))$$

**EP 0 569 700 B1**

Die Intensität I ist in Fig. 4 für V=I als Funktion der Phase $\phi$ dargestellt. Zur Signaldetektion ist in Fig. 5 das Homodyn-Detektionsverfahren mit aktiver Phasenkompensation eingesetzt (siehe EP-A1-0 433 824). Dieses Verfahren hat den Vorteil einer hohen Messgenauigkeit bei gleichzeitig einfacher Elektronik.

Die Differenz $\phi^0_1(t)$-$\phi^0_2(t)$ wird auf pi/2 modulo 2*pi geregelt, der Term A*sin($\omega$*t) wird durch eine zusätzliche, gegenphasige Modulation kompensiert. Dazu ist ein piezoelektrischer Modulator 8 vorgesehen, der von einem Quadraturregler 11 gesteuert wird. Der Quadraturregler 11 erhält sein Einganssignal von zwei am Ausgangsende der Referenzfaser 5b angeordneten Detektoren 9a und 9b. Diese wandeln die beiden gegenphasigen Interferenzsignale, die sich aus der Interferenz der beiden Moden ergeben, in elektrische Signale um, aus denen mittels eines nachgeschalteten Subtrahierers 10 die Differenz gebildet wird. Durch die Differenzbildung werden die DC-Offsets der Detektorausgangsspannungen eliminiert. Aus dem Steuersignal des Quadraturreglers 11 wird mittels eines Hochpasses 12 das Messsignal extrahiert und an einem Signalausgang 13 zur Verfügung gestellt.

Zur Vermeidung von Missverständnissen sei angemerkt, dass auch bei einem Faser-Mode-Zehnder Interferometer ein Modulator vorgesehen ist, welcher auf eine (Monomode) Referenzfaser wirkt. Dieser würde hier der $LP_{11}$-Modus der Sensorfaser entsprechen.

Indem die Messmittel eine zweite Zwei-Moden-Faser 5b enthalten und der Modulator 8 auf diese zweite Zwei-Moden-Faser wirkt, kann die Sensorfaser 5a auf den unmittelbaren Bereich des Sensorelements 7 beschränkt werden und muss nicht die Distanz zwischen Sensorelement 7 und Auswerteeinheit 14 überbrücken. Die erste Sensorfaser 5a kann mit Vorteil dadurch mit dem Sensorelement 7 einen kompakten und einfach aufgebauten Sensorkopf 15 bilden, der nur durch die unempfindliche Monomode-Faser 3 mit der Auswerteeinheit 14 verbunden ist, in der sich die Referenzfaser 5b, der Modulator 8 samt Ansteuerung sowie auch die Lichtquelle 1 und der Faserkoppler 2 befinden. Die Terme A*sin($\omega$*t) und $\phi^0_1(t)$-$\phi^0_2(t)$ können im übrigen auch - wie bereits früher beschrieben - mit zwei separaten Modulatoren anstelle des Modulators 8 kompensiert werden.

Die beiden (polarisationserhaltenden) Zwei-Moden-Fasern 5a, 5b haben vorzugsweise einen Kern mit elliptischem Querschnitt. Die Faserparameter können dann so gewählt werden, dass für die Wellenlänge der Laserdiode nur der $LP_{01}$- und der gerade $LP_{11}$-Modus ausbreitungsfähig sind (siehe den eingangs zitierten Artikel von B. Y. Kim et al.). In Fasern mit rundem Kern wäre gleichzeitig mit dem geraden auch der ungerade LP11-Modus ausbreitungsfähig.

Die Monomode-Faser 3 ist vorzugsweise polarisationserhaltend ausgebildet. Es kann jedoch auch eine gewöhnliche Monomode-Faser verwendet werden. Die Polarisation müsste dann aktiv kontrolliert werden, wie dies in T. Pikaar et al., J. Lightw. Tech. _7_, 1982-1987 (1989) beschrieben ist.

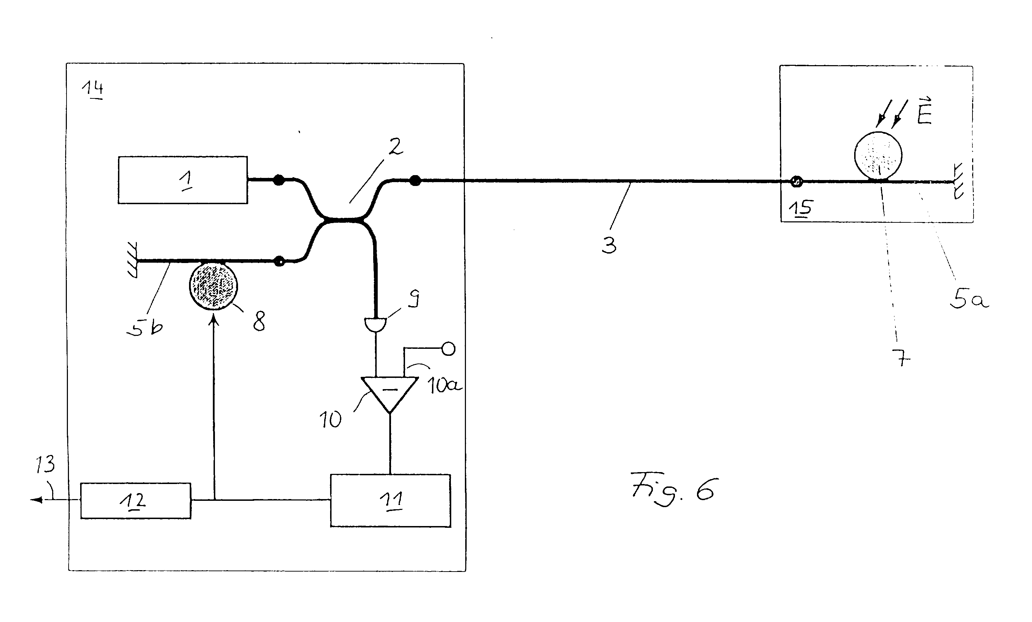

In Fig. 6 wird die Referenzfaser 5b in Reflexionskonfiguration betrieben. Wie bei Fig. 5 wird ein Homodyn-Detektionssystem sowie ein Faserkoppler 2 verwendet. Wenn die Referenzfaser in Reflexion betrieben und zur Aufspaltung des Lichtweges ein Faserkoppler (monomode) verwendet wird, steht am Detektorausgang des Faserkopplers grundsätzlich nur eines der beiden gegenphasigen Interferenzsignale zur Verfügung. Entsprechend ist in Fig. 6 auch nur ein Detektor 9 vorgesehen. An den zweiten Eingang 10a des Subtrahierers 10 muss deshalb eine zusätzliche DC-Offsetspanung angelegt werden. Diese wird so gewählt, dass sie sowohl den DC-Offset der Interferenzmodulation

$$(19) \qquad I = I_0 \ (I + 1/2 \ V \cos \phi(t))$$

kompensiert, als auch den zusätzlichen Offset, der durch das Licht der Lichtquelle 1 erzeugt wird, welches auf direktem Weg von der Lichtquelle 1 über den Faserkoppler 2 zum Detektor 9 gelangt.

Bei der Ausführungsform gemäss Fig. 7 wird die Referenzfaser ebenfalls in Reflexionskonfiguration betrieben. Anstelle eines Faserkopplers ist hier jedoch ein Strahlteiler 2' verwendet. Zur Strahlein- und Auskopplung sind sog. Selfoc-Linsen 16 (0.25 - picht Linsen) vorgesehen. Die Lichtstrahlbündel zwischen Lichtquelle 1 und Strahlteiler 2' einerseits und zwischen diesem und den Detektoren 9a, 9b andererseits sind kollimiert. Bei der Ausführungsform gemäss Fig. 7 stehen beide gegenphasigen Interferenzsignale zur Verfügung, so dass die DC-Offsets der Detektorausgangsspannungen durch Bildung ihrer Differenz eliminiert werden können.

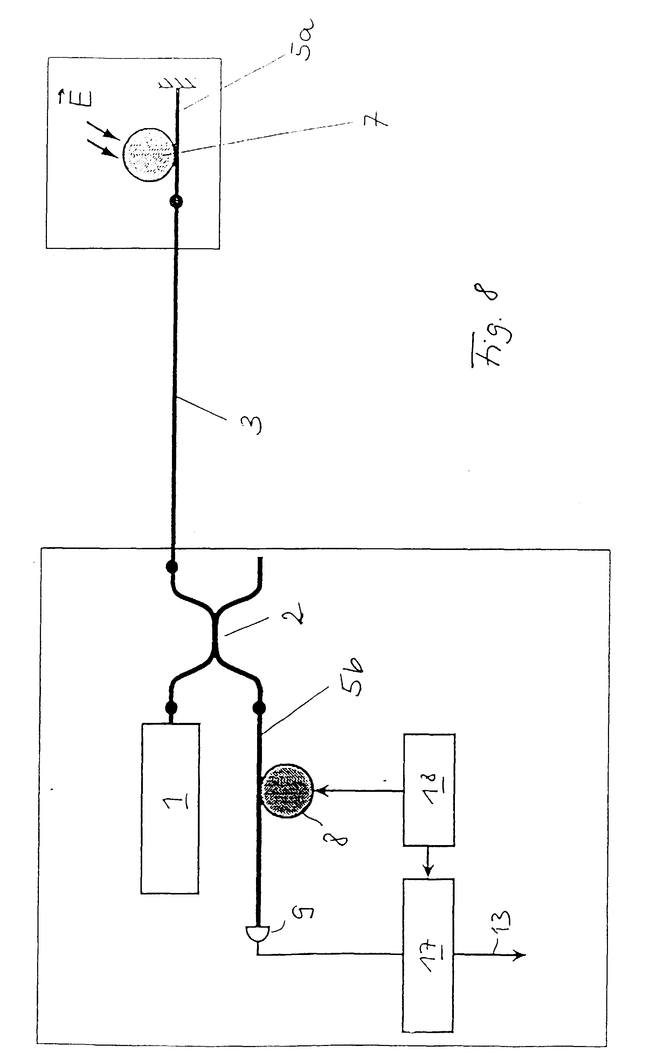

Fig. 8 zeigt die Referenzfaser 5b wieder in Transmissionskonfiguration. Zur Aufspaltung des Lichtweges ist auch wieder ein Faserkoppler 2 verwendet. Die Signaldemodulation erfolgt hier mit Hilfe des eingangs erwähnten Homodyn-Verfahrens, bei dem eine Träger-Phasenmodulatlon erzeugt wird, bzw. mit Hilfe des eingangs ebenfalls bereits erwähnten synthetischen Heterodyn-Verfahrens. Für beide Verfahren sind die Blockschemata identisch; sie unterscheiden sich lediglich in der Art der Demodulationselektronik, welche gesamthaft mit 17 bezeichnet ist. Der Modulator 8 wird von einem Oszillator 18 mit geeignet gewählter Amplitude und Frequenz angesteuert, wobei das Oszillatorsignal auch der Demodulationselektronik 17 zugeführt ist. Die Demodulationselektronik liefert ein zur zu messenden Phasenmodulation A*sin($\omega$*t) proportionales Ausgangssignal. Für beide Demodulationsverfahren ist es weiter ausreichend, lediglich eines der beiden gegenphasigen Interferenzsignale auszuwerten. Entsprechend ist auch nur ein Detektor 9 vorgesehen.

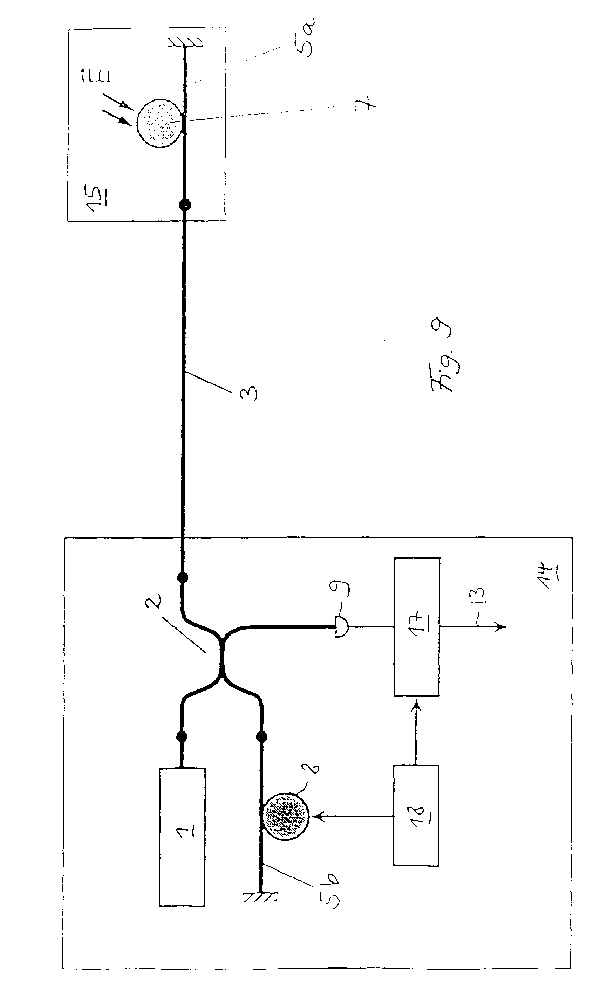

Die Fig. 9 entspricht derjenigen von Fig. 8 bis auf den Unterschied, dass für die Referenzfaser 5b wieder eine Reflexionsgeometrie gewählt ist. Dass es für die im Zusammenhang mit Fig. 8 erwähnten Demodulationsverfahren ausreichend ist, lediglich eine der beiden gegenphasigen Interferenzsignale auszuwerten, ist hier insofern von Vorteil, als bei der Verwendung eines Faserkopplers (monomode) und dem Betrieb der Referenzfaser in Reflexionsgeometrie am Detektorausgang des Faserkopplers sowieso nur eines der beiden gegenphasigen Interfernzsignale zur Verfügung steht. Darauf wurde im Zusammenhang mit Fig. 6 ja bereits hingewiesen.

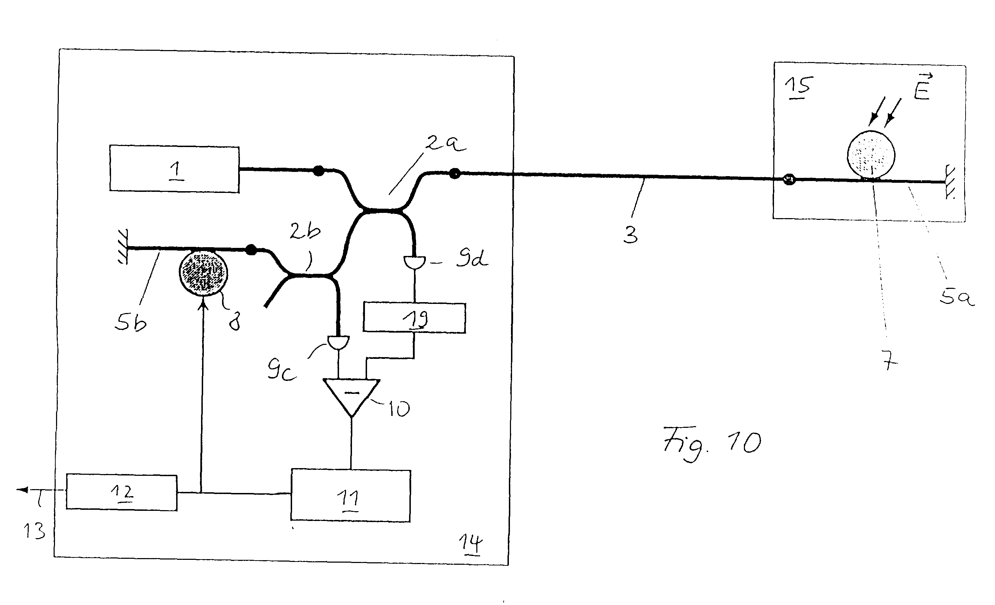

Fig. 10 zeigt eine Abwandlung der Konfiguration von Fig. 6 entsprechend der Erfindung. Anstelle eines Faserkopplers 2 sind hier zwei Faserkoppler 2a, 2b verwendet. Am Detektorausgang jedes Faserkopplers ist jeweils ein Detektor 9c bzw. 9d vorgesehen. Durch die Verwendung der zwei Faserkoppler kann vermieden werden, dass Licht von der Lichtquelle 1 auf direktem Weg zum Detektor 9c gelangt und den im Zusammenhang mit Fig. 6 erwähnten DC-Offset verursacht. Das Ergebnis ist ein verbessertes Signal/Rausch-Verhältnis. Ausserdem steht ein weiterer Ausgang zur Verfügung, an dem vermittels des zweiten Detektors 9d das direkte Licht von der Lichtquelle 1 gemessen werden kann. Aus dem entsprechenden Messignal wird in Fig. 10 über eine Einheit 19 die Spannung für den zweiten Eingang 10a des Subtrahierers 10 abgeleitet. Diese Spannung dient dazu, den DC-Offset der Interferenzmodulation auszugleichen, welcher zu der von der Lichtquelle 1 abgestrahlten Lichtintensität proportional ist. Etwaige Fluktuationen der Lichtintensität und dieses Offsets können dadurch inhärent kompensiert werden.

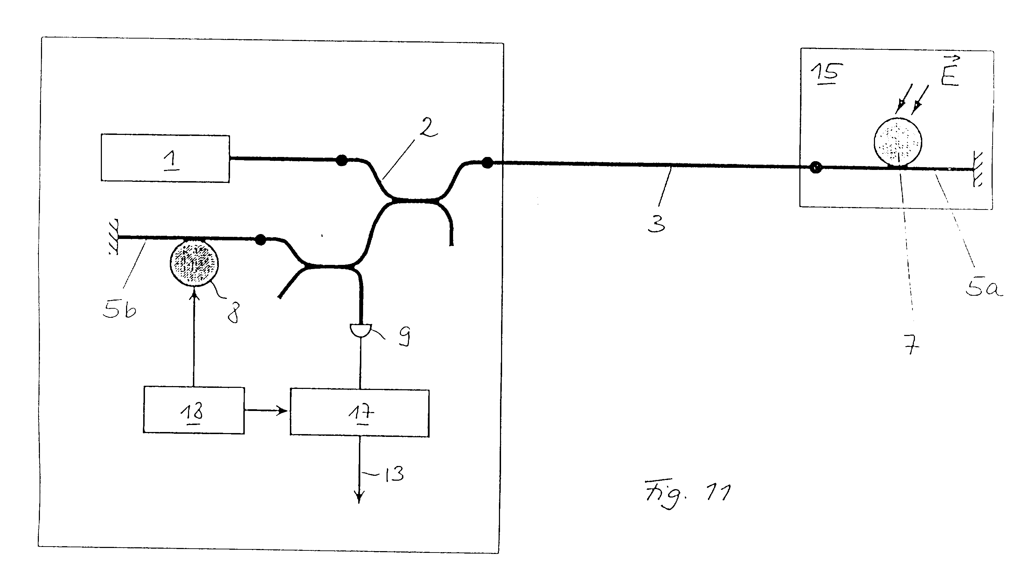

In Fig. 11 ist eine Abwandlung der Konfiguration von Fig. 9 entsprechend der Erfindung dargestellt, wobei ebenfalls zwei Faserkoppler verwendet sind.

Analog zu den Ausführungsformen gemäss den Fig. 10 und 11 können bei der in Fig. 7 dargestellten Ausführungsform zwei Strahlteiler verwendet werden, um auch hier zu verhindern, dass Licht von der Lichtquelle 1 direkt die Detektoren 9a, 9b erreicht.

In den vorbeschriebenen Ausführungsbeispielen wurde stets angenommen, dass die beiden Zwei-Moden-Fasern 5a, 5b hinsichtlich ihrer Faserparameter übereinstimmen. Andererseits wurde weiter oben bereits erwähnt, dass die beiden Zwei-Moden-Fasern prinzipiell auch unterschiedliche Faserparameter aufweisen könnten. Neben unterschiedlichen effektive Faserlängen, könnten die beiden Fasern z.B. insbesondere auch verschiedene Werte von Delta $n^{(1)}_{eff}$ und Delta $n^{(2)}_{eff}$ aufweisen. Die effektiven Faserlängen $l_1$ und $l_2$ müssten dann so angepasst werden, dass mit

$$\text{Delta } L_1 = l_1 * \text{Delta } n^{(1)}_{eff}$$

$$\text{Delta } L_2 = l_2 * \text{Delta } n^{(2)}_{eff}$$

weiterhin gilt

$$\text{Delta } L_1 = \text{Delta } L_2 = \text{Delta } L$$

Die Gangunterscheide Delta $L_1$ und Delta $L_2$ sind dabei natürlich nach wie vor so zu wählen, dass der Interferenzkontrast (V) für diese Gangunterschiede (Delta L1, Delta $L_2$) und für die Summe dieser Gangunterschiede (Delta $L_1$ + Delta $L_2$) jeweils ungefähr gleich Null ist und für die Differenz dieser Gangunterschiede (Delta $L_1$ - Delta $L_2$) ein absolutes oder relatives Maximum annimmt.

**Patentansprüche**

1. Faseroptischer Sensor für elektrische Wechselfelder und - spannungen, umfassend

    a) eine Mehr-Moden-Laserdiode als Lichtquelle (1);
    b) ein piezoelektrisches Sensorelement (7);
    c) eine erste Zwei-Moden-Faser (5a) mit einem Eingangsende und einem anderen Ende, in der sich der $LP_{01}$-Grundmodus und der gerade $LP_{11}$-Modus ausbreiten können, und welche zumindest teilweise an dem Sensorelement (7) so fixiert ist, dass eine Dimensionsänderung des Sensorelements (7) in einem elektrischen Feld (E) zu einer Längenänderung in der ersten Zwei-Moden-Faser (5a) führt;
    d) Mittel (14) zum Messen der feldbedingten Längenänderung der ersten Zwei-Moden-Faser(5a), welche Mittel eine zweite Zwei-Moden-Faser (5b) umfassen, wobei
    e) die Parameter der beiden Zwei-Moden-Fasern (5a, 5b) und damit die relativen Gangunterschiede (Delta

$L_1$, Delta $L_2$), die die Moden in den einzelnen Zwei-Moden-Fasern akkumulieren, so auf die Kohärenzeigenschaften der Lichtquelle abgestimmt sind, dass der Interferenzkontrast (V) für die genannten Gangunterschiede (Delta $L_1$, Delta $L_2$) und für die Summe dieser Gangunterschiede (Delta $L_1$ + Delta $L_2$) jeweils ungefähr gleich Null ist und für die Differenz der genannten Gangunterschiede (Delta $L_1$ - Delta $L_2$) ein absolutes oder relatives Maximum annimmt; und

f) die zweite Zwei-Moden-Faser zumindest teilweise an einem piezoelektrischen Modulator (8) fixiert ist;

dadurch gekennzeichnet, dass

g) das andere Ende der ersten Zwei-Moden-Faser (5a) verspiegelt ist;

h) zur Übertragung von Licht zwischen der Lichtquelle (1) sowie den Messmitteln (14) einerseits und dem Eingangsende der ersten Zwei-Moden-Faser andererseits genau eine Monomode-Faser (3) vorgesehen ist;

i) die zweite Zwei-Moden-Faser (5b) durch einseitige Verspiegelung in Reflexionskonfiguration betrieben ist;

j) zur Einkopplung von Licht von der Lichtquelle (1) in die Monomode-Faser (3) sowie zur Auskopplung von an dem anderen Ende der ersten Zwei-Moden-Faser (5a) reflektiertem Licht aus der Monomode-Faser (3) in die zweite Zwei-Moden-Faser (5b) ein Strahlteiler (2') vorgesehen ist;

k) zur Messung der Interferenz der sich in der zweiten Zwei-Moden-Faser (5b) ausbreitenden Moden zwei Detektoren (9a, 9b) vorgesehen sind;

l) die Ausgangssignale der beiden Detektoren (9a, 9b) über einen Subtrahierer (10) auf den Eingang eines Quadraturreglers (11) geführt sind;

m) der Ausgang des Quadraturreglers (11) den Modulator (8) steuert; und

n) das Ausgangssignal des Quadraturreglers (11) über einen Hochpass (12) auf einen Signalausgang (13) geführt ist.

**2.** Faseroptischer Sensor für elektrische Wechselfelder und - spannungen gemäss der Merkmale a) - i) von Anspruch 1, wobei

a) zur Einkopplung von Licht von der Lichtquelle (1) in die Monomode-Faser (3) sowie zur Auskopplung von an dem anderen Ende der ersten Zwei-Moden-Faser (5a) reflektiertem Licht aus der Monomode-Faser (3) in die zweite Zwei-Moden-Faser (5b) zwei Strahlteiler verwendet sind, wobei ein erster Strahlteiler mit der Lichtquelle und der Monomode-Faser (3) und der zweite Strahlteiler mit einem Zweig des ersten Strahlteilers sowie der zweiten Zwei-Moden-Faser verbunden ist;

b) zur Messung der Interferenz der sich in der zweiten Zwei-Moden-Faser (5b) ausbreitenden Moden zwei Detektoren vorgesehen sind;

c) die Detektoren an einen Zweig des zweiten Strahlteilers angeschlossen ist;

d) das Ausgangssignal der Detektoren über einen Subtrahierer auf den Eingang eines Quadraturreglers geführt ist;

e) der Ausgang des Quadraturreglers den Modulator steuert; und

f) das Ausgangssignal des Quadraturreglers über einen Hochpass auf einen Signalausgang geführt ist.

**3.** Faseroptischer Sensor für elektrische Wechselfelder und - spannungen gemäss der Merkmale a) - i) von Anspruch 1, wobei

a) zur Einkopplung von Licht von der Lichtquelle (1) in die Monomode-Faser (3) sowie zur Auskopplung von an dem anderen Ende der ersten Zwei-Moden-Faser (5a) reflektiertem Licht aus der Monomode-Faser (3) in die zweite Zwei-Moden-Faser (5b) zwei Faserkoppler (2a, 2b) verwendet sind, wobei ein erster Faserkoppler (2a) mit der Lichtquelle (1) und der Monomode-Faser (3) und der zweite Faserkoppler (2b) mit einem Ausgang des ersten Faserkopplers (2a) und der zweiten Zwei-Moden-Faser (5b) verbunden ist;

b) zur Messung der Interferenz der sich in der zweiten Zwei-Moden-Faser (5b) ausbreitenden Moden ein erster Detektor (9c) vorgesehen ist;

c) der erste Detektor (9c) an einem Ausgang des zweiten Faserkopplers (2b) angeschlossen ist;

d) das Ausgangssignal des ersten Detektors (9c) über einen Subtrahierer (10) auf den Eingang eines Quadraturreglers (11) geführt ist;

e) an den Subtrahierer (10) neben dem Ausgangssignal des ersten Detektors (9c) noch das Ausgangssignal eines zweiten Detektors (9d) gelegt ist;

f) der zweiter Detektor (9d) an einen Ausgang des ersten Faserkopplers (2a) angeschlossen ist;

g) der Ausgang des Quadraturreglers (11) den Modulator (8) steuert; und

h) das Ausgangssignal des Quadraturreglers (11) über einen Hochpass (12) auf einen Signalausgang (13) geführt ist.

4. Faseroptischer Sensor für elektrische Wechselfelder und - spannungen gemäss der Merkmale a) - i) von Anspruch 1, wobei

   a) zur Einkopplung von Licht von der Lichtquelle (1) in die Monomode-Faser (3) sowie zur Auskopplung von an dem anderen Ende der ersten Zwei-Moden-Faser (5a) reflektiertem Licht aus der Monomode-Faser (3) in die zweite Zwei-Moden-Faser (5b) zwei Faserkoppler verwendet sind, wobei ein erster Faserkoppler mit der Lichtquelle (1) und der Monomode-Faser (3) und der zweite Faserkoppler mit einem Ausgang des ersten Faserkopplers sowie der zweiten Zwei-Moden-Faser (5b) verbunden ist;
   b) zur Messung der Interferenz der sich in der zweiten Zwei-Moden-Faser (5b) ausbreitenden Moden ein Detektor (9) vorgesehen ist;
   c) der Detektor (9) an einen Ausgang des zweiten Faserkopplers angeschlossen ist;
   d) das Ausgangssignal des Detektors (9) einer Demodulationselektronik (17) zugeführt ist;
   e) der Modulator (8) von einem Oszillator (18) angesteuert ist;
   f) das Oszillatorsignal auch der Demodulationselektronik (17) zugeführt ist; und
   g) das Ausgangssignal der Demodulationselektronik (17) einem Signalausgang (13) zugeführt ist.

5. Faseroptischer Sensor für elektrische Wechselfelder und - spannungen nach einem der Ansprüche 1 - 4, dadurch gekennzeichnet, dass

   a) die Zwei-Moden-Fasern (5a, 5b) einen Kern mit elliptischem Querschnitt aufweisen; und
   b) die Monomode-Faser (3) polarisationserhaltend ist.

6. Faseroptischer Sensor für elektrische Wechselfelder und - spannungen nach einem der Ansprüche 1 - 5, dadurch gekennzeichnet, dass die Ankopplung an die beiden Zwei-Moden-Fasern (5a, 5b) jeweils so ausgeführt ist, dass die in diesen ausbreitungsfähigen Moden jeweils mit ungefähr gleicher Intensität angeregt werden.

7. Faseroptischer Sensor für elektrische Wechselfelder und - spannungen nach einem der Ansprüche 1 - 6, dadurch gekennzeichnet, dass die effektiven Brechungsindex-Unterschiede $n(LP_{01}) - n(LP_{11})$ für die beiden Moden in den beiden Zwei-Moden-Fasern (5a, 5b) sowie die effektiven Längen der beiden Zwei-Moden-Fasern (5a, 5b) jeweils gleich sind.

8. Faseroptischer Sensor für elektrische Wechselfelder und - spannungen nach einem der Ansprüche 1 - 7, dadurch gekennzeichnet, dass

   a) die Lichtquelle (1), der bzw. die Faserkoppler (2, 2a, 2b) oder der bzw. die Strahlteiler (2'), die zweite Zwei-Moden-Faser (5b) mit dem Modulator (8) und dem bzw. den Detektor/en (9, 9a, 9b, 9c, 9d) und die zugehörig Elektronik (10, 11, 12, 17, 18) zu einer Auswerteeinheit (14) zusammengefasst sind;
   b) die erste Zwei-Moden-Faser (5a) mit dem Sensorelement (7) in einem separaten Sensorkopf (15) angeordnet sind; und
   c) Sensorkopf (15) und Auswerteeinheit (14) nur durch die eine Monomode-Faser (3) miteinander in Verbindung stehen.

**Claims**

1. Fibre-optic sensor for alternating electric fields and voltages, comprising

   (a) a multimode laser diode as light source (1);
   (b) a piezoelectric sensor element (7);
   (c) a first double-mode fibre (5a) having an input end and another end, in which fibre the $LP_{01}$ fundamental mode and the even $LP_{11}$ mode can propagate, and which fibre is fixed at least partially to the sensor element (7) in such a manner that a dimensional alteration of the sensor element (7) in an electric field (E) leads to a length alteration in the first double-mode fibre (5a);
   (d) means (14) for measuring the field-dependent length alteration of the first double-mode fibre (5a), which means comprise a second double-mode fibre (5b),
   (e) the parameters of the two double-mode fibres (5a, 5b) and thus the relative path differences (Delta $L_1$,

Delta $L_2$) which the modes accumulate in the individual double-mode fibres, being tuned to the coherence properties of the light source so that the interference contrast (V) for the said path differences (Delta $L_1$, Delta $L_2$) and for the sum of these path differences (Delta $L_1$ + Delta $L_2$) is in each instance approximately equal to zero and for the difference of the said path differences (Delta $L_1$ - Delta $L_2$) adopts an absolute or relative maximum; and

(f) the second double-mode fibre being fixed at least partially to a piezoelectric modulator (8);

characterized in that

(g) the other end of the first double-mode fibre (5a) is mirrored;

(h) for the transmission of light between the light source (1) and the measuring means (14) on the one hand and the input end of the first double-mode fibre on the other hand, precisely one monomode fibre (3) is provided;

(i) the second double-mode fibre (5b) is operated in reflection configuration, by being mirrored at one end;

(j) a beam splitter (2') is provided for the coupling-in of light from the light source (1) into the monomode fibre (3) as well as for the coupling-out of light reflected at the other end of the first double-mode fibre (5a) from the monomode fibre (3) into the second double-mode fibre (5b);

(k) two detectors (9a, 9b) are provided for the measurement of the interference of the modes propagating in the second double-mode fibre (5b);

(l) the output signals of the two detectors (9a, 9b) are passed via a subtractor (10) to the input of a quadrature controller (11);

(m) the output of the quadrature controller (11) controls the modulator (8); and

(n) the output signal of the quadrature controller (11) is passed via a high-pass filter (12) to a signal output (13).

2. Fibre-optic sensor for alternating electric fields and voltages according to the features a) - i) of Claim 1, in which

(a) two beam splitters are used for the coupling-in of light from the light source (1) into the monomode fibre (3) as well as for the coupling-out of light reflected at the other end of the first double-mode fibre (5a) from the monomode fibre (3) into the second double-mode fibre (5b), a first beam splitter being connected to the light source and the monomode fibre (3), and the second beam splitter being connected to a branch of the first beam splitter as well as the second double-mode fibre;

(b) two detectors are provided for the measurement of the interference of the modes propagating in the second double-mode fibre (5b);

(c) the detectors are connected to a branch of the second beam splitter;

(d) the output signal of the detectors is passed via a subtractor to the input of a quadrature controller;

(e) the output of the quadrature controller controls the modulator; and

(f) the output signal of the quadrature controller is passed via a high-pass filter to a signal output.

3. Fibre-optic sensor for alternating electric fields and voltages according to the features a) - i) of Claim 1, in which

(a) two fibre couplers (2a, 2b) are used for the coupling-in of light from the light source (1) into the monomode fibre (3) as well as for the coupling-out of light reflected at the other end of the first double-mode fibre (5a) from the monomode fibre (3) into the second double-mode fibre (5b), a first fibre coupler (2a) being connected to the light source (1) and the monomode fibre (3), and the second fibre coupler (2b) being connected to an output of the first fibre coupler (2a) and the second double-mode fibre (5b);

(b) a first detector (9c) is provided for the measurement of the interference of the modes propagating in the second double-mode fibre (5b);

(c) the first detector (9c) is connected to an output of the second fibre coupler (2b);

(d) the output signal of the first detector (9c) is passed via a subtractor (10) to the input of a quadrature controller (11);

(e) not only the output signal of the first detector (9c) but also the output signal of a second detector (9d) is applied to the subtractor (10);

(f) the second detector (9d) is connected to an output of the first fibre coupler (2a);

(g) the output of the quadrature controller (11) controls the modulator (8); and

(h) the output signal of the quadrature controller (11) is passed via a high-pass filter (12) to a signal output (13).

4. Fibre-optic sensor for alternating electric fields and voltages according to the features a) - i) of Claim 1, in which

(a) two fibre couplers are used for the coupling-in of light from the light source (1) into the monomode fibre (3) as well as for the coupling-out of light reflected at the other end of the first double-mode fibre (5a) from the monomode fibre (3) into the second double-mode fibre (5b), a first fibre coupler being connected to the light source (1) and the monomode fibre (3), and the second fibre coupler being connected to an output of the first fibre coupler as well as the second double-mode fibre (5b);

(b) a detector (9) is provided for the measurement of the interference of the modes propagating in the second double-mode fibre (5b);

(c) the detector (9) is connected to an output of the second fibre coupler;

(d) the output signal of the detector (9) is fed to a demodulating electronic system 17;

(e) the modulator (8) is driven by an oscillator (18);

(f) the oscillator signal is also fed to the demodulating electronic system (17); and

(g) the output signal of the demodulating electronic system (17) is fed to a signal output (13).

5. Fibre-optic sensor for alternating electric fields and voltages according to one of Claims 1 - 4, characterized in that

(a) the double-mode fibres (5a, 5b) exhibit a core with elliptical cross-section; and

(b) the monomode fibre (3) is polarization-maintaining.

6. Fibre-optic sensor for alternating electric fields and voltages according to one of Claims 1 - 5, characterized in that the coupling to the two double-mode fibres (5a, 5b) is in each instance designed in such a manner that the modes which can propagate in these are in each instance excited with approximately equal intensity.

7. Fibre-optic sensor for alternating electric fields and voltages according to one of Claims 1 - 6, characterized in that the effective refractive index differences $n(LP_{01}) - n(LP_{11})$ for the two modes in the two double-mode fibres (5a, 5b) as well as the effective lengths of the two double-mode fibres (5a, 5b) are respectively equal.

8. Fibre-optic sensor for alternating electric fields and voltages according to one of Claims 1 - 7, characterized in that

(a) the light source (1), the fibre coupler or fibre couplers (2, 2a, 2b) or the beam splitter or beam splitters (2'), the second double-mode fibre (5b) with the modulator (8) and the detector or detectors (9, 9a, 9b, 9c, 9d) and the associated electronic system (10, 11, 12, 17, 18) are combined to form an evaluation unit (14);

(b) the first double-mode fibre (5a) together with the sensor element (7) are disposed in a separate sensor head (15); and

(c) sensor head (15) and evaluation unit (14) are connected to one another only by the one monomode fibre (3).

**Revendications**

1. Capteur à fibre optique pour les champs électriques alternés et les tensions, comprenant :

a) une diode laser multimodale comme source de lumière (1) ;

b) un élément capteur piézoélectrique (7) ;

c) une première fibre bimodale (5a) munie d'une extrémité d'entrée et d'une autre extrémité, dans laquelle peuvent se propager le mode de base $LP_{01}$ et le mode pair $LP_{11}$, et qui est fixée au moins en partie à l'élément capteur (7) de manière à ce qu'une variation dimensionnelle de l'élément capteur (7) dans un champ électrique (E) donne lieu à une variation de longueur dans la première fibre bimodale (5a) ;

d) des moyens (14) pour mesurer la variation de longueur en fonction du champ de la première fibre bimodale (5a), lesdits moyens comprenant une deuxième fibre bimodale (5b),

e) les paramètres des deux fibres bimodales (5a, 5b) et ainsi les déphasages relatifs (Delta $L_1$, Delta $L_2$) qui accumulent les modes dans chacune des fibres bimodales étant accordés sur les propriétés de cohérence de la source de lumière de manière à ce que le contraste d'interférence (V) soit quasiment égal à zéro pour lesdits déphasages (Delta $L_1$, Delta $L_2$) et pour la somme de ces déphasages (Delta $L_1$ + Delta $L_2$) et prenne un maximum absolu ou relatif pour la différence desdits déphasages (Delta $L_1$ - Delta $L_2$) ; et

f) la deuxième fibre bimodale étant fixée au moins partiellement à un modulateur piézoélectrique (8) ;

caractérisé par le fait que

g) l'autre extrémité de la première fibre bimodale (5a) est réfléchissante ;

h) une fibre monomodale (3) est précisément prévue pour transmettre la lumière entre la source de lumière (1) et les moyens de mesure (14) d'un côté et l'extrémité d'entrée de la première fibre bimodale de l'autre côté ;

i) la deuxième fibre bimodale (5b) est utilisée dans une configuration en réflexion par une réflexion d'un seul côté ;

j) une lame séparatrice (2') est prévue pour injecter la lumière en provenance de la source de lumière (1) dans la fibre monomodale (3) et pour découpler la lumière réfléchie à l'autre extrémité de la première fibre bimodale (5a) de la fibre monomodale (3) dans la deuxième fibre bimodale (5b) ;

k) deux détecteurs (9a , 9b) sont prévus pour mesurer l'interférence des modes qui se propagent dans la deuxième fibre bimodale (5b) ;

l) les signaux de sortie des deux détecteurs (9a, 9b) sont acheminés à l'entrée d'un régulateur de quadrature (11) par le biais d'un soustracteur (10) ;

m) la sortie du régulateur de quadrature (11) commande le modulateur (8) ; et

n) le signal de sortie du régulateur de quadrature (11) est acheminé à une sortie signal (13) par le biais d'un filtre passe-haut (12).

2. Capteur à fibre optique pour les champs électriques alternés et les tensions selon les caractéristiques a) - i) de la revendication 1, dans lequel

a) deux lames séparatrices sont utilisées pour injecter la lumière en provenance de la source de lumière (1) dans la fibre monomodale (3) et pour découpler la lumière réfléchie à l'autre extrémité de la première fibre bimodale (5a) de la fibre monomodale (3) dans la deuxième fibre bimodale (5b), une première lame séparatrice étant reliée à la source de lumière et à la fibre monomodale (3) et la deuxième lame séparatrice étant reliée à une branche de la première lame séparatrice ainsi qu'à la deuxième fibre bimodale ;

b) deux détecteurs sont prévus pour mesurer l'interférence des modes qui se propagent dans la deuxième fibre bimodale (5b) ;

c) les détecteurs sont raccordés à une branche de la deuxième lame séparatrice ;

d) le signal de sortie des détecteurs est acheminé à l'entrée d'un régulateur de quadrature par le biais d'un soustracteur ;

e) la sortie du régulateur de quadrature commande le modulateur ; et

f) le signal de sortie du régulateur de quadrature est acheminé à une sortie signal par le biais d'un filtre passe-haut.

3. Capteur à fibre optique pour les champs électriques alternés et les tensions selon les caractéristiques a) - i) de la revendication 1, dans lequel

a) deux coupleurs de fibre (2a, 2b) sont utilisés pour injecter la lumière en provenance de la source de lumière (1) dans la fibre monomodale (3) et pour découpler la lumière réfléchie à l'autre extrémité de la première fibre bimodale (5a) de la fibre monomodale (3) dans la deuxième fibre bimodale (5b), un premier coupleur de fibre (2a) étant relié à la source de lumière (1) et à la fibre monomodale (3) et le deuxième coupleur de fibre (2b) étant relié à une sortie du premier coupleur de fibre (2a) ainsi qu'à la deuxième fibre bimodale (5b) ;

b) un premier détecteur (9c) est prévu pour mesurer l'interférence des modes qui se propagent dans la deuxième fibre bimodale (5b) ;

c) le premier détecteur (9c) est raccordé à une sortie du deuxième coupleur de fibre (2b) ;

d) le signal de sortie du premier détecteur (9c) est acheminé à l'entrée d'un régulateur de quadrature (11) par le biais d'un soustracteur (10) ;

e) le signal de sortie d'un deuxième détecteur (9d) est également appliqué au soustracteur (10) en plus du signal de sortie du premier détecteur (9c) ;

f) le deuxième détecteur (9d) est raccordé à une entrée du premier coupleur de fibre (2a);

g) la sortie du régulateur de quadrature (11) commande le modulateur (8) ; et

h) le signal de sortie du régulateur de quadrature (11) est acheminé à une sortie signal (13) par le biais d'un filtre passe-haut (12).

4. Capteur à fibre optique pour les champs électriques alternés et les tensions selon les caractéristiques a) - i) de la revendication 1, dans lequel

a) deux coupleurs de fibre sont utilisés pour injecter la lumière en provenance de la source de lumière (1) dans la fibre monomodale (3) et pour découpler la lumière réfléchie à l'autre extrémité de la première fibre bimodale (5a) de la fibre monomodale (3) dans la deuxième fibre bimodale (5b), un premier coupleur de fibre étant relié à la source de lumière (1) et à la fibre monomodale (3) et le deuxième coupleur de fibre étant relié à une sortie du premier coupleur de fibre ainsi qu'à la deuxième fibre bimodale (5b) ;

b) un détecteur (9) est prévu pour mesurer l'interférence des modes qui se propagent dans la deuxième fibre bimodale (5b) ;

c) le détecteur (9) est raccordé à une sortie du deuxième coupleur de fibre ;

d) le signal de sortie du détecteur (9) est acheminé à un circuit électronique de démodulation (17) ;

e) le modulateur (8) est commandé par un oscillateur (18) ;

f) le signal de l'oscillateur est également acheminé au circuit électronique de démodulation (17) ;

g) le signal de sortie du circuit électronique de démodulation (17) est acheminé à une sortie signal (13).

5. Capteur à fibre optique pour les champs électriques alternés et les tensions selon l'une des revendications 1 à 4, caractérisé par le fait que

a) les fibres bimodales (5a, 5b) ont une âme de section elliptique ; et

b) la fibre monomodale (3) est à polarisation constante.

6. Capteur à fibre optique pour les champs électriques alternés et les tensions selon l'une des revendications 1 à 5, caractérisé par le fait que le couplage aux deux fibres bimodales (5a, 5b) est à chaque fois réalisé de manière à ce que les modes qui s'y propagent soient systématiquement stimulés avec une intensité presque identique.

7. Capteur à fibre optique pour les champs électriques alternés et les tensions selon l'une des revendications 1 à 6, caractérisé par le fait que la différence des indices de réfraction efficaces $n(LP_{01}) - n(LP_{11})$ ainsi que les longueurs efficaces des deux fibres bimodales (5a, 5b) soient identiques pour les deux modes dans les deux fibres bimodales (5a, 5b).

8. Capteur à fibre optique pour les champs électriques alternés et les tensions selon l'une des revendications 1 à 6, caractérisé par le fait que

a) la source de lumière (1), le ou les coupleur(s) de fibre (2, 2a, 2b) ou la ou les lame(s) séparatrice(s) (2'), la deuxième fibre bimodale (5b) sont regroupés avec le modulateur (8) et le ou les détecteur(s) (9, 9a, 9b, 9c, 9d) et l'électronique (10, 11 , 12, 17, 18) correspondante pour former une unité de traitement (14) ;

b) la première fibre bimodale (5a) est logée avec l'élément capteur (7) dans une tête de capteur (15) séparée ; et

c) la tête de capteur (15) et l'unité de traitement (14) ne sont reliées entre elles que par une fibre monomodale (3).

FIG.1

FIG. 2

FIG. 3A

FIG. 3B

FIG. 4

Fig. 5

Fig. 6

Fig. 7

EP 0 569 700 B1

Fig. 8

Fig. 9

Fig. 10

25

EP 0 569 700 B1

Fig. 11